Europäisches Patentamt

(19) European Patent Office

Office européen des brevets

(11) Publication number: **0 017 405
B1**

## (12) EUROPEAN PATENT SPECIFICATION

(45) Date of publication of patent specification: **06.02.85**

(21) Application number: **80300891.1**

(22) Date of filing: **21.03.80**

(51) Int. Cl.⁴: **B 23 K 15/00**

(54) **Method of treating a workpiece with an electron beam.**

| | |
|---|---|
| (30) Priority: **23.03.79 JP 34768/79**<br>**06.06.79 JP 70038/79** | (73) Proprietor: **Hitachi, Ltd.**<br>**5-1, Marunouchi 1-chome**<br>**Chiyoda-ku Tokyo 100 (JP)** |
| (43) Date of publication of application:<br>**15.10.80 Bulletin 80/21** | (72) Inventor: **Kita, Hisanao**<br>**4-17-22 Suwa**<br>**Hitachi Ibaraki (JP)**<br>Inventor: **Karatsu, Yoshinori**<br>**203-6 Takahagi**<br>**Takahagi Ibaraki (JP)**<br>Inventor: **Nakazaki, Takamitsu**<br>**2590-22 Ishitaki**<br>**Takahagi Ibaraki (JP)**<br>Inventor: **Akutsu, Yoji**<br>**1--5-3-403 Nishinarusawa**<br>**Hitachi Ibaraki (JP)** |
| (45) Publication of the grant of the patent:<br>**06.02.85 Bulletin 85/06** | |
| (84) Designated Contracting States:<br>**DE FR GB** | |
| (56) References cited:<br>**DE-B-1 184 435**<br>**US-A-3 617 686** | (74) Representative: **Paget, Hugh Charles Edward**<br>**et al**<br>**MEWBURN ELLIS & CO. 2/3 Cursitor Street**<br>**London EC4A 1BQ (GB)** |

Courier Press, Leamington Spa, England.

## Description

This invention relates to a method of treating a workpiece with an electron beam e.g. welding.

Apparatus for treating a workpiece with an electron beam is exemplified by an electron beam welder, which has a vacuum chamber for welding in which the workpiece is placed. A vacuum chamber for an electron beam gun in which an electron beam generator is disposed is connected air-tightly to the welding chamber, and the electron beams are directed towards the workpiece through an aperture in the wall of the welding chamber. Such apparatus is disclosed, for example, in US—A—3,617,686 and DE—B—1184935.

In such apparatus, it is generally necessary to evacuate the welding chamber and the electron beam gun chamber by means of a vacuum pump and to maintain them at high vacuum of about $1 \times 10^{-4}$ ($1.33 \times 10^{-2}$ Pa) Torr and about $1 \times 10^{-5}$ to $1 \times 10^{6}$ Torr ($1.33 \times 10^{-3}$ to $1.33 \times 10^{-4}$ Pa), respectively. However, gases contained in the workpiece such as $H_2$ and $O_2$ and the material of the workpiece itself converted into metal vapor are emitted from the surface of the workpiece during welding and eventually lower the vacuum in both vacuum chambers. If a large number of molecules enter the electron beam gun chamber the insulation effect of the vacuum in the proximity of anode and cathode is reduced, so that microdischarge and flash-over discharge occur. Microdischarge results in the formation of blow-holes at the weld zone while flash-over discharge leads to the formation of recesses of the surface beads, blow-holes and sags. If flash-over discharge occurs, furthermore, an excess current relay operates to stop operation of the apparatus in order to protect it.

These discharge phenomena occur frequently when the thickness of the workpiece exceeds 100 mm because the number of gas molecules and metal vapor molecules formed during welding increases with increasing thickness of the workpiece. When a 100 mm thick killed steel is welded, for example, microdischarge occurs 1 to 5 times within 10 minutes and the flash-over discharge does about once in 20 minutes. The vacuum in this instance is $1 \times 10^{-3}$ Torr ($1.33 \times 10^{-1}$ Pa) near the aperture in the wall of the welding chamber, $1 \times 10^{-2}$ Torr ($1.33$ Pa) near the workpiece and $10^{-5}$ to $10^{-6}$ Torr ($1.33 \times 10^{-3}$ to $1.33 \times 10^{-3}$ to $1.33 \times 10^{-4}$ Pa) inside the electron beam gun chamber. Thus, the pressure ratio between the region near the aperture in the welding chamber and the electron beam gun chamber may be as large as $10^2$—$10^3$, so that the gas and metal molecules are liable to be sucked into the electron beam gun chamber. In consequence, molecules emitted from the surface of the workpiece enter the electron beam gun chamber and instantaneously reduce the vacuum near the anode and cathode down to $10^{-3}$—$10^{-4}$ Torr ($1.33 \times 10^{-1}$ to $1.33 \times 10^{-2}$ Pa), thereby causing the discharge phenomena. Because of such discharge phenomena, it has been difficult in the conventional apparatus to weld, cut or bore a workpiece of a thickness of 10 mm or more by means of electron beams.

It is therefore an object of the present invention to provide a method for treating a workpiece with an electron beam which is suitable for use with thick workpieces, and in particular is free from the occurrence of discharge phenomena in the electron beam generator during treatment.

The invention as claimed is intended to provide a solution.

Discharge near the anode and cathode of the electron beam gun occurs because gas molecules (including metal vapor molecules) generated at the workpiece during treatment reach the electron beam gun. Molecules that are emitted from the surface of the workpiece with kinetic energy can travel only their free path. If the workpiece is spaced from the electron beam gun by a distance greater than the mean free path of these molecules therefore, the number of molecules capable of reaching the electron beam gun is much reduced so that the discharge phenomena can be checked.

An embodiment of the invention will now be described by way of example with reference to the accompanying drawings, in which:—

Figure 1 is a sectional view of apparatus embodying the present invention;

Figure 2 is a diagrammatic sectional view on the line II—II of Fig. 1;

Figure 3 is a diagrammatic sectional view on the line III—III of Figure 1;

Figure 4 is a graph showing the relationship between the frequency of discharge D and the distance M between the electron beam gun and the workpiece; and

Figure 5 is a graph showing the relationship between the thickness T obtainable in piercing-welding and the distance M between the electron beam gun and the workpiece.

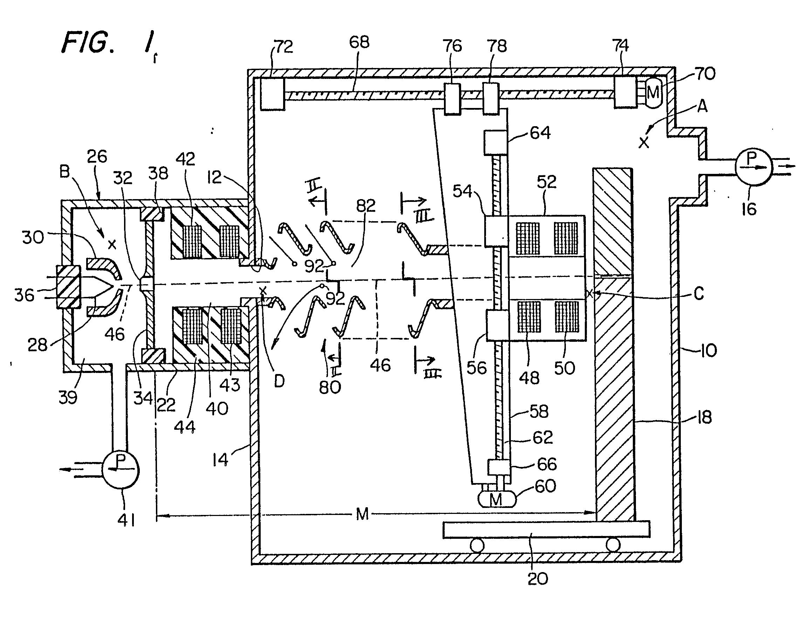

Figure 1 shows a sealed vacuum chamber 10 for welding having a front wall 14 with a beam aperture 12. The vacuum chamber 10 has the shape of a rectangular parallelepiped having a length of 6.5 m, a width of 6.5 m and a height of 3.5 m, for example and in use is kept constantly at a high vacuum of $1 \times 10^{-4}$ ($1.33 \times 10^{-2}$ Pa) Torr by means of a vacuum pump 16. In order to support a workpiece 18 to be welded movably inside the vacuum welding chamber 10, a movable work table 20 is disposed in the chamber.

A vacuum chamber 22 is disposed beyond the aperture 12 of the vacuum chamber 10 and is connected air tightly to the vacuum chamber 10. The chamber 22 comprises an electron beam gun 26 consisting of a tungsten ribbon type filament 28, a grid or cathode 30 and an anode 34 with an aperture 32. These parts are fixed inside the chamber 22 by insulators 36 and 38 and are electrically connected to a power source (not shown). The chamber 22 is divided by the anode 34 into chambers 39 and 40 so that the chamber 39 containing the filament 28 is kept constantly at a high vacuum in the $1 \times 10^{-5}$ to $1 \times 10^{-6}$ Torr ($1.33 \times 10^{-3}$ to $1.33 \times 10^{-4}$ Pa) by means of a vacuum pump 41.

A focussing coil 42 and a deflecting coil 43 are disposed downstream of the anode 34 inside the vacuum chamber 22. A coil bobbin 44 is fixed onto the inner circumference of the vacuum chamber 22 and supports the focussing and deflecting coils 42, 43. When the filament 28 is heated, electrons are emitted from the grid or cathode 30. The electron beams pass into the vacuum chamber 10 through the aperture 32 of the anode, the focussing coil 42, the deflecting coil 43 and the aperture 12 of the vacuum chamber 10. The beam intensity is selected so as sufficiently to pierce and fuse the workpiece.

A focussing coil 48 and a deflecting coil 50 are arranged around the beam path adjacent the workpiece 18 in the vacuum chamber 10 and are supported by a coil bobbin 52 which has screw coupling by which it can be moved vertically in the vacuum chamber 10. A support 58, which is mounted for horizontal movement in the vacuum chamber 10, carries a screw 62 in bearings 64, 66 that are rotated by a motor 60. The coupling members 54 and 56 engage the screw 62 so that when the motor 60 is energized by the power source (not shown) to rotate the screw 62, the bobbin 52 is caused to move up or down.

To effect horizontal movement of the support 58 towards or away from the workpiece 18, at the upper portion of the vacuum chamber 10 are disposed horizontal screw 68 mounted in bearings 72, 74 and a motor 70 for rotating this screw 68. Screw coupling members 76, 78 fixed to the support 58 engage this screw 68, so that when the motor 70 is energized by a power source (not shown) to rotate the screw 68, the members 76, 78 move to the right or to the left. This direction of movement of the support 58 is parallel to the axis of the electron beam 46.

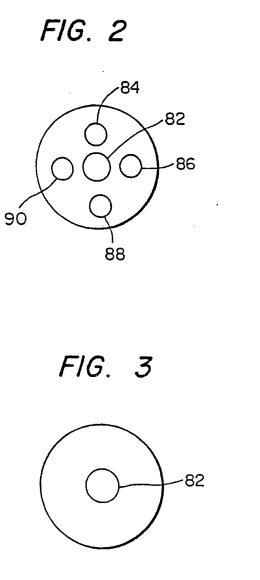

An electron beam guide 80 of the bellows-like form is interposed between the focussing coil 43 and the deflecting coil 48. As illustrated by Figure 2, a beam path 82, and exhaust apertures 84, 86, 88 and 90 are defined by this beam guide 80. This arrangement prevents the diffusion into the electron beam path of the molecules of gas and metal vapor that are generated upon irradiation of the workpiece by the electron beam. Molecules 92 inside the electron beam guide 80 are discharged into the vacuum chamber 10 through the exhaust apertures 84, 86, 88, 90 as indicated in Figure 1.

When the filament 28, the cathode 30, the anode 34, the focussing coils 42, 48 and the deflecting coils 43, 50 are all suitably connected to power sources, the electron beam 46 emitted from the electron beam gun 26 passes horizontally through the focussing coil 42, the deflecting coil 43, the electron beam guide 80 of the bellows-like form, the focussing coil 48 and the deflecting coil 50 and impinges upon the workpiece 18. If the distance M between the anode 34 and the workpiece 18 is large, the electron beam 46 expands but is again focussed by the focussing coil 48 that is disposed in the proximity of the workpiece. The focussing coil 48 and the deflecting coil 50 are adjusted vertically so as to bring the axis of the electron beam 46 emitted from the electron beam gun 26 into conformity with the axes of the focussing coil 48 and deflecting coil 50. This correction is made by controlled operation of the motor 60.

The distance M between the anode 34 and the workpiece is controlled by operation of the motor 70 to move the coils 48, 50 and by movement of the work table 20. The distance apart of the rear wall of the vacuum chamber 10 and the anode 34 is sufficient so that the distance M can in any envisaged operation be greater than the mean free path of molecules of gas and metal vapor generated during welding, such as hydrogen and oxygen molecules. In this embodiment, the distance M is at least 1.85 m.

For instance, when the workpiece is 100 mm-thick carbon steel and the distance between the focussing coil 42 and the workpiece 18 is 2.5 m in Figure 1, the vacuum is $1 \times 10^{-4}$ Torr ($1.33 \times 10^{-2}$ Pa) at point A in the vacuum chamber 10, $1 \times 10^{-5}$ to $1 \times 10^{-6}$ Torr ($1.33 \times 10^{-3}$ to $1.33 \times 10^{-4}$ Pa) at point B in the vacuum chamber 39, $1 \times 10^{-2}$ Torr ($1.33$ Pa) at point C in front of the workpiece 18 and $1 \times 10^{-4}$ Torr ($1.33 \times 10^{-2}$ Pa) at point D close to the aperture 12, respectively. Thus, it is possible to maintain the vacuum of at least $1 \times 10^{-4}$ Torr ($1.33 \times 10^{-2}$) near the aperture 12 during welding.

. As a result, micro-discharge generated by the electron beam gun 26 occurs less than once in 60 minutes and flash-over discharge is not observed at all. This is because the distance M between the workpiece 18 and the anode 34 is so large that metal vapor and gas molecules generated at the weld zone are evacuated by the vacuum pump 16, thereby reducing the quantity of them sucked into the vacuum chamber 39 through the aperture 32 of the anode 34.

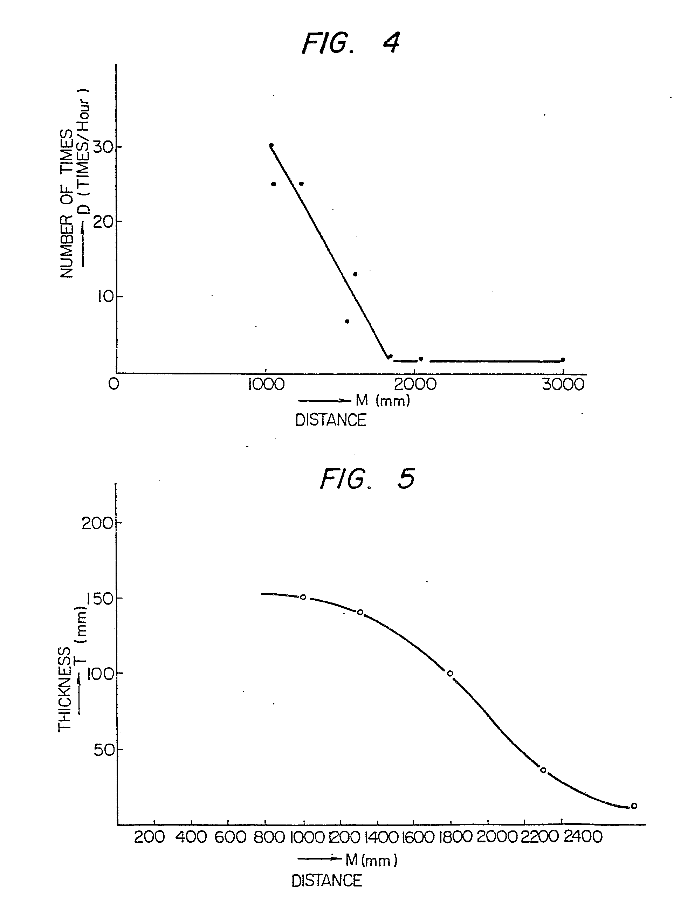

Figure 4 illustrates the relationship between the frequency of occurrence of micro-discharge and the distance M between anode 34 and the workpiece 18. As can be seen, the frequency of micro-discharge decreases drastically when the distance M exceeds 1.85 m. This is because the mean free path of the metal vapor and gas molecules during welding is about 1.85 m and when the distance M becomes smaller than this metal vapour and gas molecules enter the vacuum chamber of the electron beam gun 39 in greater quantities.

Figure 5 is a diagram showing the effect of the focussing coil 48 of Figure 1. The thickness T of the workpiece that can be pierce-welded in the absence of the coil 48 is plotted against the distance M between the anode 34 and the workpiece 18. The focussing effect of the focussing coil 42 decreases with increase in the distance M, so that scattering of the beam becomes greater and the weldable thickness of the workpiece is reduced. In the embodiment of Figure 1 however, the further focussing coil 48 is placed immediately before the workpiece 18 so that the electron beam is again focussed. Welding of thick workpiece can therefore be achieved even if the distance M is made greater than 1.85 m, and at the same time the discharge phenomena are minimized.

In Figure 1, both focussing coil 48 and deflecting coil 50 are shown disposed inside the vacuum chamber 10. However, they may be disposed inside the vacuum chamber 22 by increasing the length of the chamber 22. In such a case, the size of the vacuum chamber 10 can be reduced.

## Claims

1. A method of treating a workpiece arranged in a vacuum chamber (10) with an electron beam wherein the electron beam (46) is generated by an electron beam source (26) having a filament (28), a grid or cathode (30) and an anode (34) with an aperture (32), and the electron beam passing through the said aperture of the anode is focussed and directed through an entry aperture (12) of said vacuum chamber onto the workpiece (18) characterized in that;

the electron beam source is located in a further vacuum chamber (39) kept during the treatment at a pressure in the range of $1 \times 10^{-5}$ to $1 \times 10^{-6}$ Torr ($1.33 \times 10^{-3}$ to $1.33 \times 10^{-4}$ Pa), and the workpiece, made of a ferrous material, is 100 mm or more in thickness and is at a distance greater than 1.85 m from said anode (34) of said electron beam source, the said vacuum chamber (10) containing the workpiece being kept during the treatment at a pressure of about $1 \times 10^{-4}$ Torr ($1.33 \times 10^{-2}$ Pa) or less.

2. A method according to claim 1 wherein at least two focussing coils (42, 48) act to focus the electron beam, a first one (42) of these coils being in the proximity of the anode (34) and the second one (48) being in the proximity of the workpiece (18).

## Revendications

1. Procédé de traitement d'une pièce à traiter disposée dans une chambre à vide (10) moyennant l'utilisation d'un faisceau électronique, et selon lequel le faisceau électronique (46) est produit par une source (26) de faisceau électronique comportant un filament (28) et une grille ou cathode (30) et une anode (34) munie d'une ouverture (32), et le faisceau électronique traversant ladite ouverture de l'anode est focalisé et est dirigé à travers une ouverture d'entrée (12) de la chambre à vide, sur la pièce à traiter (18), caractérisé en ce que la source de faisceau électronique est située dans une autre chambre à vide (39) maintenue pendant le traitement à une pression située dans la gamme de $1 \times 10^{-5}$ à $1 \times 10^{-6}$ torr ($1,33 \times 10^{-3}$ à $1,33 \times 10^{-4}$ Pa), et que la pièce à traiter, constituée en un matériau ferreux, possède une épaisseur de 100 mm ou plus et est située à une distance par rapport à ladite anode (34) de ladite source de faisceau électronique, qui est supérieure à 1,85 m, ladite chambre à vide (10) contenant la pièce à traiter étant maintenue, pendant le traitement, à une pression égale à environ $1 \times 10^{-4}$ torr ($1,33 \times 10^{-2}$ Pa) ou moins.

2. Procédé selon la revendication 1, selon lequel au moins deux bobines de focalisation (42, 48) agissent de manière à focaliser le faisceau électronique, une première (42) de ces bobines étant située à proximité de l'anode (34) et la seconde (48) étant située à proximité de la pièce à traiter (18).

## Patentansprüche

1. Verfahren zum Bearbeiten eines in einer Vakuumkammer (10) angeordneten Werkstücks mit einem Elektronenstrahl, wobei der Elektronenstrahl (46) von einer einen Faden (28), ein Gitter oder eine Kathode (30) und eine Anode (34) mit einer Öffnung (32) aufweisenden Elektronenstrahlquelle (26) erzeugt und der die Öffnung der Anode durchsetzende Elektronenstrahl fokussiert und durch eine Eintrittsöffnung (12) der Vakuumkammer hindurch auf das Werkstück (18) gerichtet wird, dadurch gekennzeichnet, daß die Elektronenstrahlquelle in einer während der Bearbeitung auf einem Druck im Bereich von $1 \times 10^{-5}$ bis $1 \times 10^{-6}$ Torr ($1,33 \times 10^{-3}$ bis $1,33 \times 10^{-4}$ Pa) gehaltenen weiteren Vakuumkammer (39) angeordnet wird und das aus Eisenmaterial bestehende Werkstück eine Dicke von 100 mm oder mehr aufweist und sich in einem Abstand von mehr als 1,85 m von der Anode (34) der Elektronenstrahlquelle befindet, wobei die das Werkstück enthaltende Vakuumkammer (10) während der Bearbeitung auf einem Druck von etwa $1 \times 10^{-4}$ Torr ($1,33 \times 10^{-2}$ Pa) oder weniger gehalten wird.

2. Verfahren nach Anspruch 1, wobei mindestens zwei Fokussierspulen (42, 48) eine Fokussierung des Elektronenstrahls bewirken, wobei sich eine erste (42) dieser Spulen in der Nähe der Anode (34) und die zweite (48) in der Nähe des Werkstücks (18) befinden.

FIG. 1

0017 405

# FIG. 2

# FIG. 3

## FIG. 4

## FIG. 5

3